# EUROPÄISCHE PATENTANMELDUNG

(11) **EP 2 237 649 A2**
(43) Veröffentlichungstag der Anmeldung: **06.10.2010**
(21) Anmeldenummer: 10003032.9
(22) Anmeldetag: 23.03.2010
(51) Int. Cl.: H05K 1/00

(54) **Filter, insbesondere zur Filterung elektromagnetischer Störungen**

(30) Priorität: 30.03.2009 DE 102009014859
(71) Anmelder: Phoenix Contact GmbH & Co. KG, 32825 Blomberg (DE)
(72) Erfinder: Kiefer, Arno, 33175 Bad Lippspringe (DE)
(74) Vertreter: Gesthuysen, von Rohr & Eggert

(57) **Zusammenfassung**

Beschrieben und dargestellt ist ein Filter, insbesondere zur Filterung von elektromagnetischen Störungen, mit einem Basiselement (2), mit mindestens einem elektrischen Filterbauelement (3, 4) und mit mindestens zwei Eingangs-Anschlusskontakten (5) und mindestens zwei Ausgangs-Anschlusskontakten (6) zum Anschluss der Leiter einer elektrischen Leitung, wobei die Eingangs-Anschlusskontakte (5) über auf dem Basiselement (2) angeordnete Leiterpfade (7) mit den Ausgangs-Anschlusskontakten (6) verbunden sind.

Bei dem erfindungsgemäßen Filter ist eine einfache Konfiguration und eine flexible Anwendung dadurch sichergestellt, dass in jedem Leiterpfad (7) mindestens zwei Längskontakte (8) vorgesehen sind, über die ein Filterbauelement (3, 4) derart mit einem Leiterpfad (7) elektrisch verbindbar ist, dass die elektrische Verbindung des Leiterpfades (7) zwischen den beiden Längskontakten (8) über das Filterbauelement (3, 4) führt, und dass in den Leiterpfaden (7) jeweils mindestens ein Querkontakt (9) vorgesehen ist, so dass zwei Leiterpfade (7) über ein Filterbauelement (3, 4) elektrisch miteinander verbunden sind, wenn das Filterbauelement (3, 4) mit den Querkontakten (9) der beiden Leiterpfade (7) elektrisch verbunden ist.

## Beschreibung

Die Erfindung betrifft einen Filter, insbesondere zur Filterung von elektromagnetischen Störungen, mit einem Basiselement, mit mindestens einem elektrischen Filterbauelement und mit mindestens zwei Eingangs-Anschlusskontakten und mindestens zwei Ausgangs-Anschlusskontakten zum Anschluss der Leiter einer elektrischen Leitung, wobei die Eingangs-Anschlusskontakte über auf dem Basiselement angeordnete Leiterpfade mit den Ausgangs-Anschlusskontakten verbunden sind. Darüber hinaus betrifft die Erfindung noch ein Basiselement für ein Filter, mit mindestens zwei Eingangs-Anschlusskontakten und mindestens zwei Ausgangs-Anschlusskontakten zum Anschluss der Leiter einer elektrischen Leitung, wobei die Eingangs-Anschlusskontakte über Leiterpfade mit den Ausgangs-Anschlusskontakten verbunden sind.

Der Einfluss von elektromagnetischen Störungen auf eine elektrische Anlage kann durch Filter, so genannte EMV-Filter (Elektromagnetische Verträglichkeit) minimiert oder verhindert werden. EMV-Filter, bei denen es sich in der Regel um Tiefpassfilter handelt, filtern sowohl Immissionen als auch Anlagenemissionen, d.h. sie dienen einerseits dazu, eine Anlage gegen den Einfluss von externen elektromagnetischen Störsignalen zu schützen, andererseits schützen sie weitere Anlagen oder elektrische Einrichtungen vor den Störsignalen, die von der Anlage verursacht werden. Mit EMV-Filtern wird versucht, eine schlechte Impedanzanpassung zwischen Eingangs- und Ausgangsseite zu erreichen, so dass eine maximale Reflexion der Störsignale entsteht. EMV-Filter werden häufig an den externen elektrischen Leitungen einer Anlage, beispielsweise auf der Speiseleitung vorgesehen. Ein Hauptanwendungsgebiet für EMV-Filter sind beispielsweise Frequenzumrichter.

Ein EMV-Filter muss individuell auf die Anlagenkonfiguration und Störsignalcharakteristik einer elektrischen Anlage abgestimmt sein, damit eine ausreichende Filterwirkung erzielt wird. Hersteller für EMV-Filter müssen daher eine große Auswahl von verschiedenen Filtern anbieten, um die Bedürfnisse möglichst vieler Anwendungsbereiche abdecken zu können. Es wird eine Vielzahl von Filtern angeboten, die sich für unterschiedlichste Anwendungszwecke und Störsignale eignen, wobei die Filter vorkonfigurierte Bauteile sind, die in die zu schützenden Anlagen direkt integriert werden können. Die Filter werden hauptsächlich anhand ihrer elektrischen Spezifikationen, z.B. Arbeitsspannung und maximal zulässiger Strom, gewählt.

Für komplexe Anlagen werden häufig auch individuelle Filterlösungen angeboten. Mit dem Ziel die Auswahl an verschiedenen Filtern reduzieren zu können und die Herstellung einer individuellen Filterlösung zu vereinfachen, beschreibt die DE 203 16 051 U1 ein EMV-Filter zur Filterung von elektromagnetischen Störungen auf elektrischen Leitungen, bei dem der mechanische Aufbau modular ausgeführt ist. Der bekannte Filter weist ein zentrales Gerüst auf, das die mechanische Basis des EMV-Filters bildet und an dem einzelne Bauelemente montiert werden können. Die Montage erfolgt derart, dass die einzelnen Bauelemente an dem zentralen Gerüst voneinander isoliert angebracht und durch eine Verkabelung - zumindest teilweise - miteinander verbunden werden. Für die Verbindung wird vorzugsweise eine Lötverbindung vorgeschlagen.

Die Gestaltung nach der DE 203 16 051 U1 hat den Nachteil, dass die an dem zentralen Gerüst befestigten Bauelemente mit hohem Verdrahtungsaufwand untereinander in Kontakt verbracht werden müssen, wobei sich die Konfiguration des Filters nach der Montage nicht ändern lässt.

Der vorliegenden Erfindung liegt daher die Aufgabe zugrunde, ein Filter anzugeben, das einfach zu konfigurieren und in seiner Anwendung flexibel ist.

Die vorgenannte Aufgabe wird erfindungsgemäß bei einem Filter der eingangs genannten Art gelöst, indem in jedem Leiterpfad mindestens zwei Längskontakte vorgesehen sind, über die ein Filterbauelement derart mit einem Leiterpfad elektrisch verbindbar ist, dass die elektrische Verbindung des Leiterpfades zwischen den beiden Längskontakten über das Filterbauelement führt, und dass in den Leiterpfaden jeweils mindestens ein Querkontakt vorgesehen ist, so dass zwei Leiterpfade über ein Filterbauelement elektrisch miteinander verbunden sind, wenn das Filterbauelement mit den Querkontakten der beiden Leiterpfade elektrisch verbunden ist.

Das erfindungsgemäße Filter hat den Vorteil, dass es variabel an unterschiedliche oder sich verändernde Anwendungen angepasst werden kann, ohne dass das Filter ausgebaut und durch ein ganz neues Filter ersetzt werden muss. Die Filterwirkung kann nach der Installation des Basiselements, durch das Montieren von einem oder mehreren elektrischen Filterbauelementen, auf die entsprechende Störcharakteristik der jeweiligen elektrischen Anlage angepasst und abgestimmt werden. In Abhängigkeit von der gewünschten Filterwirkung, können elektrische Filterbauelemente über zwei Längskontakte in einen Leiterpfad eingebracht oder die beiden Leiterpfade durch die Querkontakte über ein elektrisches Filterbauelement elektrisch miteinander verbunden werden. Die Filterdimensionierung kann somit bedarfsgerecht direkt vor Ort vorgenommen oder bei sich ändernden Bedingungen angepasst werden.

Die Längskontakte sind derart vorgesehen, dass zwischen zwei einander zugeordneten Längskontakten eines Leiterpfads eine elektrisch leitende Verbindung besteht, wenn kein Filterbauelement mit den beiden Längskontakten verbunden ist. Bei montiertem Filterbauelement erfolgt die elektrische Verbindung über das Filterbauelement, die direkte elektrische Verbindung zwischen den beiden Längskontakten wird somit unterbrochen. Zwischen zwei Längskontakten eines Leiterpfads ist dazu vorzugsweise ein als Öffner ausgebildetes Schaltelement angeordnet, so dass die Längskontakte direkt miteinander verbunden sind, wenn kein Filterbauelement mit den Längskontakten verbunden ist. Ist dagegen ein Filterbauelement mit zwei Längskontakten verbunden, so wird die direkte Verbindung zwischen den Längskontakten unterbrochen; die Längskontakte sind dann über das Filterbauelement miteinander verbunden, d. h. das Filterbauelement in den Leiterpfad integriert.

Die Querkontakte unterschiedlicher Leiterpfade weisen keine elektrisch leitende Verbindung untereinander auf, wobei durch Montieren eines Filterbauelements zwischen zwei Querkontakten eine elektrisch leitende Verbindung über das Filterbauelement hergestellt wird. Da die Längskontakte und die Querkontakte vorzugsweise konstruktiv identisch ausgestaltet sind, kann ein Längskontakt eines Leiterpfades folglich auch als Querkontakt, zur Herstellung einer Querverbindung mit einem Querkontakt oder einem Längskontakt eines anderen Leiterpfades verwendet werden. Daraus ergibt sich, dass im Rahmen der vorliegenden Patentanmeldung die Begriffe "Längskontakt" und "Querkontakt" funktional bezüglich ihres Zusammenwirkens mit einem Filterbauelement und nicht konstruktiv zu verstehen sind.

Die jeweilige Filterwirkung des Filters hängt davon ab, welche und wie viele Filterbauelemente und an welcher Stelle der Leiterpfade mit dem Basiselement verbunden werden. In der Regel ergibt sich die Filterwirkung somit durch eine Kombination einer Mehrzahl von Filterbauelementen, die - entsprechend dem jeweiligen Anwendungsfall - mit den Längskontakten oder den Querkontakten verbunden sind, d. h. in die einzelnen Leiterpfade eingebaut sind. Grundsätzlich besteht jedoch auch die Möglichkeit, dass nur ein einzelnes Filterbauelement in einem Leiterpfad oder zwischen zwei Leiterpfaden, eingebaut ist. Das erfindungsgemäße Filter hat den Vorteil, dass die Filterdimensionierung erst unmittelbar vor Ort erfolgen kann, und dass bei einer Änderung der Anlagenkonfiguration das Filter nicht vollständig erneuert werden muss, sondern lediglich eine oder mehrere elektrische Filterbauelemente ausgetauscht, erneuert oder zusätzlich integriert werden müssen, wodurch sich die Filterwirkung ändert. Nachdem das Filter einmal installiert ist, können Änderungen und Verbesserungen der Filterwirkung somit, durch Austauschen oder Hinzufügen von Filterbauelementen, auch im laufenden Betrieb erfolgen.

Gemäß einer vorteilhaften Ausgestaltung des Filters ist vorgesehen, dass das Basiselement mindestens einen weiteren, dritten Leiterpfad aufweist. An diesem dritten Leiterpfad ist mindestens ein Querkontakt vorgesehen, der mit einem Filterbauelement kontaktierbar ist, so dass über das Filterbauelement ein Kontakt zu wenigstens einem der anderen beiden Leiterpfade herstellbar ist. Die elektrische Querverbindung zwischen zwei Leiterpfaden entsteht dann, wenn jeweils ein Querkontakt eines Leiterpfades über ein Filterbauelement mit einem Querkontakt eines weiteren Leiterpfades elektrisch verbunden ist.

Bei der Ausgestaltung des Filters mit drei Leiterpfaden hat es sich als vorteilhaft herausgestellt, wenn zwei Leiterpfade sowohl über Längskontakte als auch über Querkontakte verfügen und der dritte Leiterpfad nur Querkontakte aufweist. Dabei ist der dritte Leiterpfad mit seinen Querkontakten über ein Filterbauelement mit den Querkontakten wenigstens eines weiteren Leiterpfades elektrisch verbindbar, so dass eine Querverbindung über ein Filterbauelement zwischen wenigstens zwei Leiterpfaden herstellbar ist. Mit "elektrisch verbindbar" soll ausgedrückt werden, dass zwischen den Leiterpfaden eine Verbindung über ein elektrisches Filterbauelement besteht. Die Ausgestaltung mit drei Leiterpfaden ist beispielsweise für einphasige Netze vorgesehen, wobei an die drei Eingangs- bzw. Ausgangs-Anschlusskontakte entsprechend ein erster Leiter, ein Neutralleiter und ein Schutzleiter angeschlossen sind.

Das erfindungsgemäße Filter ist bei einer entsprechenden Ausgestaltung sowohl für einphasige Netze als auch für dreiphasige Netze geeignet. Eine bevorzugte Ausgestaltung beispielsweise für dreiphasige Netze sieht vor, dass insgesamt fünf Leiterpfade auf dem Basiselement angeordnet sind. Vier dieser fünf Leiterpfade verfügen sowohl über Längs- als auch Querkontakte, während der fünfte Leiterpfad nur Querkontakte aufweist. Der fünfte - nur Querkontakte aufweisende - Leiterpfad ist dabei mit mindestens einem der anderen vier Leiterpfade über mindestens ein Filterbauelement elektrisch verbindbar.

Eine weitere Ausgestaltung sieht vor, dass nicht nur der jeweils nur Querkontakte aufweisende Leiterpfad mit einem oder mehreren Leiterpfaden elektrisch verbindbar ist, sondern dass auch die Leiterpfade, die sowohl über Längs- als auch über Querkontakte verfügen, untereinander jeweils einzeln oder in einer Mehrzahl miteinander verbindbar sind. Diese Ausgestaltung ist sowohl bei Filtern für dreiphasige Netze mit fünf Leiterpfaden als auch bei Filtern für einphasige Netze mit drei Leiterpfaden vorgesehen.

Die Filterbauelemente, mit denen die Leiterpfade verbindbar sind, können eine Kapazität, eine Induktivität oder einen Widerstand aufweisen. Als besonders vorteilhaft haben sich jedoch Filterbauelemente erwiesen, die eine Kapazität und/oder eine Induktivität und/oder einen Widerstand aufweisen, d.h. aus einer Kombination der einzelnen Bauelemente bestehen, z.B. ein Filterbauelement, in dem ein Kondensator mit zwei Drosseln und einem Widerstand verschaltet ist.

Filterbauelemente, die beispielsweise häufig verwendete Kombinationen von einzelnen Bauelemente aufweisen (nachfolgend Kombinations-Filterbauelemente genannt), haben den Vorteil, dass beim Einrichten des Filters bereits sehr schnell eine komplexe Filterwirkung erzielt werden kann, indem diese Kombinations-Filterbauelemente montiert werden. Die in dem Kombinations-Filterbauelement bereits angeordneten und verschalteten Bauelemente müssen folglich nicht mehr durch eine Mehrzahl von einzelnen jeweils ein Bauelement aufweisende Filterbauelementen kombiniert werden, sondern die Kombination von Bauteilen ist schon vorgefertigt und erzielt eine - für die entsprechende Verschaltung - charakteristische Filterwirkung.

Gemäß einer Variante der Erfindung sind die einzelnen Bauelemente eines Kombinations-Filterbauelements intern nicht miteinander verschaltet, sondern lediglich gemäß der Montagemöglichkeiten auf dem Basiselement relativ zueinander angeordnet, so dass bei Montage des Kombinations-Filterbauelements auf dem Basiselement eine komplexe Verschaltung der einzelnen Bauelemente über die Leiterpfade des Basiselements realisiert wird. Je nach Ausgestaltung kann auch teilweise eine Verbindung lediglich in Form eines elektrischen Leiters innerhalb des Kombinations-Filterbauelements erfolgen. So kann ein Kombinations-Filterbauelement beispielsweise so ausgestaltet sein, dass bei auf dem Basiselement aufgestecktem Kombinations-Filterbauelement im ersten Leiterpfad eine Drossel angeordnet ist, der erste Leiterpfad zusätzlich über einen Kondensator mit einem zweiten Leiterpfad querverbunden ist und zwei Längskontakte des dritten Leiterpfades über das Kombinations-Filterbauelement dadurch direkt miteinander verbunden sind, dass in dem Kombinations-Filterbauelement an der entsprechenden Position kein elektrisches Bauelement sondern lediglich ein Leiter vorgesehen ist.

Die Kombinations-Filterbauelemente werden bevorzugt in Grob-, Mittel- und Feinfilter kategorisiert, die ein unterschiedliches Tiefpassverhalten haben, so dass Störsignale mit unterschiedlicher Filtergüte, insbesondere oberhalb der Netzfrequenz, gefiltert werden. Als bevorzugte Bauelemente in den Kombinations-Filterbauelementen sind insbesondere Kondensatoren mit unterschiedlichen Kapazitäten, Spulen bzw. stromkompensierte Drosseln mit verschiedenen Induktivitäten sowie unterschiedliche Widerstände vorgesehen. Durch die Verwendung von Kombinations-Filterbauelementen kann der Aufwand und die Zeit zur Herstellung der erforderlichen Filterwirkung erheblich reduziert werden.

Bevorzugt ist ein Handbuch vorgesehen, in dem Erfahrungswerte bezüglich der Filterwirkung einzelner Kombinationen von Filterbauelementen und Kombinations-Filterbauelementen dokumentiert sind, wodurch das Erzielen der gewünschten Filterwirkung mit relativ geringem Aufwand - entsprechend einer Anleitung - ermöglicht wird. Mit einer begrenzten Anzahl an Filterbauelementen wird so ein größtmöglicher Bereich an verschiedenen Filterwirkungen erreicht, wodurch viele Anwendungsgebiete abgedeckt werden können.

Durch eine Kombination von verschiedenen oder gleichartigen Filterbauelementen auf dem Basiselement ist das erfindungsgemäße Filter flexibel auf jegliche Störsignale einstellbar. Um diese Flexibilität zusätzlich zu erhöhen, sieht eine weitere Ausgestaltung des erfindungsgemäßen Filters vor, dass die physikalischen Größen der in den Filterbauelementen vorgesehenen Drosseln, Kondensatoren oder Widerstände variabel einstellbar sind. Insbesondere ist die Kapazität und/oder die Induktivität und/oder der Widerstand eines Filterbauelements einstellbar. Die Einstellbarkeit der physikalischen Größen der Filterbauelemente ermöglicht, dass bei geringfügigen Änderungen der Störsignale oder der Anlagenkonfiguration die Filterbauelemente nicht ausgetauscht werden müssen, sondern durch ein Verändern der physikalischen Größen der Bauelemente an die neue Konfiguration bzw. die neue Störcharakteristik angepasst werden können.

Eine weitere vorteilhafte Ausgestaltung des erfindungsgemäßen Filters sieht vor, dass die Leiterpfade des Basiselements als Leiterbahnen ausgebildet sind wobei die Leiterbahnen bevorzugt auf einem aus einem Kunststoff bestehenden Basiselement aufgedampft sind.

Gemäß einer weiteren vorteilhaften Ausgestaltung der Erfindung sind die Längskontakte und die Querkontakte als Steckkontakte, insbesondere als Steckerbuchsen ausgebildet, so dass die korrespondierenden Gegensteckkontakte, insbesondere Steckerstifte aufweisenden Filterbauelemente einfach auf das Basiselement aufgesteckt werden können. Die Kombinations-Filterbauelemente weisen - je nach Ausgestaltung - eine Mehrzahl von Steckerstiften zur Kontaktierung mit Längskontakten und Querkontakten auf. Um die Filterbauelemente in ihrer Anwendung noch flexibler zu gestalten, sind die Steckerstifte bevorzugt mit einer lösbaren mechanischen Verbindung, z.B. einer Schraubverbindung, an dem Filterbauelement befestigt. Durch die lösbare Verbindung kann in Abhängigkeit vom jeweiligen Anwendungsfall ein Teil der Steckerstifte entfernt werden, um gezielt den elektrischen Kontakt einzelner Bauelemente in einem Kombinations-Filterbauelement zu unterbrechen. Vorzugsweise sind die lösbaren Steckerstifte zur besseren Übersicht farblich gekennzeichnet, wobei dafür insbesondere eine ringförmige farbige Kennzeichnung am Umfang der Steckerstifte vorgesehen ist.

Damit die Filterbauelemente gegen ein ungewolltes Ablösen vom Basiselement gesichert sind, ist vorteilhafter Weise neben der elektrischen Verbindung eine mechanische Verbindung, z.B. eine Rast- oder Clipverbindung, zwischen Filterbauelement und Basiselement vorgesehen. Besonders bevorzugt sind die elektrischen Steckerstifte dabei derart ausgestaltet, dass sie eine stabile, bevorzugt kraftschlüssige, mechanische Verbindung und gleichzeitig eine elektrische Verbindung realisieren. Um die Filterbauelement zum einen gegen elektromagnetische Störungen abzuschirmen und zum anderen zu verhindern, dass die Filterbauelement selber Störsignale aussenden, können die Filterbauelemente in einem metallischen Gehäuse oder in einem Kunststoffgehäuse mit einer aufgebrachten Metallschicht angeordnet sein.

Um das Filter einfach in eine elektrische Anlage, beispielsweise in eine Speiseleitung zu integrieren, ist vorgesehen, dass auch die Eingangs-Anschlusskontakte und die Ausgangs-Anschlusskontakte als steckbare Kontakte, bevorzugt als Steckerbuchsen ausgebildet sind, so dass das Filter problemlos und mit geringem Aufwand in einer elektrischen Anlage installiert werden kann. Die Integration des erfindungsgemäßen Filters in eine elektrische Anlage wird weiterhin dadurch vereinfacht, dass das Basiselement vorzugsweise auf einer Tragschiene montierbar, insbesondere aufrastbar ist. Durch diese Montagemöglichkeit des Basiselements auf einer Tragschiene kann das erfindungsgemäße Filter beispielsweise in einem Schaltschrank montiert werden.

Als Teil einer elektrischen Anlage ist das erfindungsgemäße Filter, gemäß einer weiteren bevorzugten Ausgestaltung, mit mindestens einem optionalen Überspannungsschutzelement ausgestattet. Das Überspannungsschutzelement ist bevorzugt steckbar ausgebildet, wobei zur elektrischen Verbindung auf dem Basiselement Steckerbuchsen angeordnet sind und das Überspannungsschutzelement korrespondierende Steckerstifte aufweist. Die Steckerbuchsen sind dabei innerhalb des Basiselements mit den Leiterpfaden verschaltet. Als Überspannungsschutzelemente können so aus dem Stand der Technik bekannte Überspannungsschutzstecker verwendet werden, die insbesondere von der Anmelderin unter der Bezeichnung PLUGTRAB PT vertrieben werden.

Unmittelbar während des Montierens der Filterbauelemente auf dem Basiselement ist die aktuell erzielte Filterwirkung nicht ersichtlich; es ist nicht bekannt wie sich die aktuelle Konfiguration des Filters auf das Störsignal auswirkt. Gemäß einer bevorzugten Ausgestaltung des Filters ist deshalb vorgesehen, dass an dem Basiselement mindestens eine, vorzugsweise zwei Anzeigeelemente vorgesehen sind, die eine Rückmeldung über die Filterwirkung in Abhängigkeit von der Art, der Anzahl und der Position der auf die Längskontakte und/oder auf die Querkontakte aufgesteckten Filterbauelemente anzeigt. Dazu ist eine Schaltung vorhanden, die das Störsignal und die Filterleistung abgleicht und ein Ausgangssignal an das Anzeigeelement liefert. Besonders bevorzugt als Anzeigeelemente sind zwei unterschiedlich farbige Leuchtdioden, die beispielsweise abhängig von einem Schwellwert das Vorliegen einer guten bzw. einer schlechten Filterwirkung signalisieren. Alternativ dazu kann auch ein Leuchtbalken vorgesehen sein, der beispielsweise in voller Länge aufleuchtet, wenn die Filterwirkung schlecht ist und keine Leuchtanzeige hat, wenn eine gute Filterwirkung erreicht ist. Der Leuchtbalken wird dann mit besser werdender Filterwirkung kontinuierlich kürzer.

Gemäß einer weiteren bevorzugten Ausgestaltung ist vorgesehen, dass auf dem Basiselement ein Deckel montierbar ist, der die Filterbauelemente und die Kontakte gegen Umwelteinflüsse abschirmt und auch einen Schutz gegen ungewolltes Entfernen der Filterbauelemente bietet. Der Deckel ist vorzugsweise auf das Basiselement aufsteckbar und mittels einer Steck- oder Rastverbindung mechanisch befestigbar. Der Deckel kann dabei auch der Abschirmung des Filters bzw. der auf dem Basiselement montierten Filterbauelemente gegen elektromagnetische Störsignale dienen. Hierzu besteht der Deckel entweder aus Metall oder aus Kunststoff, wobei der Deckel dann auf der Innen- und/oder der Außenseite mit einer Metallschicht versehen ist. Ist auch die Unterseite des Basiselements mit einer Metallschicht versehen, beispielsweise mit einer Metallschicht bedampft, so ist der Filter insgesamt gegen Störsignale von außen abgeschirmt und darüber hinaus sichergestellt, dass auch der Filter selber keine Störsignale aussendet. Dadurch kann auf die Verwendung eines zusätzlichen metallischen Gehäuses als "EMV-Gehäuse" verzichtet werden.

Neben dem zuvor beschriebenen Filter betrifft die Erfindung auch ein Basiselement, das mindestens zwei Eingangs-Anschlusskontakte und mindestens zwei Ausgangs-Anschlusskontakte zum Anschluss der Leiter einer elektrischen Leitung aufweist, wobei die Eingangs-Anschlusskontakte mit den Ausgangs-Anschlusskontakten über Leiterpfade verbunden sind. Bei dem erfindungsgemäßen Basiselement ist vorgesehen, dass in jedem Leiterpfad mindestens zwei Längskontakte zur elektrischen Verbindung mit einem Filterbauelement und mindestens ein Querkontakte ausgebildet sind. Wenn ein Filterbauelement zwischen zwei Längskontakte montiert ist, ist in die elektrische Verbindung zwischen den Eingangs-Anschlusskontakten und den Ausgangs-Anschlusskontakten das Filterbauelement eingebracht, d. h. die elektrische Verbindung des Leiterpfades zwischen den beiden Längskontakten führt über das Filterbauelement. Durch die Querkontakte können zwei Leiterpfade über ein Filterbauelement elektrisch miteinander verbunden werden, wenn ein Filterbauelement in die Querkontakte zweier Leiterpfade gesteckt ist.

Eine bevorzugte Ausgestaltung des Basiselements sieht vor, dass mindestens drei Leiterpfade auf dem Basiselement angeordnet sind, wobei einer der drei Leiterpfade wenigstens einen Querkontakt aufweist und die anderen zwei Leiterpfade jeweils mindestens zwei Längskontakte und jeweils mindestens einen Querkontakt aufweisen. Diese Anordnung von Längs- und Querkontakten ermöglicht ein flexibles Kontaktieren der drei Leiterpfaden untereinander, wobei in jeweils zwei Leiterpfaden über die Längskontakte auch jeweils ein Filterbauelement nur in die Längserstreckung des Leiterpfades zwischen Eingangs- und Ausgangs-Anschlusskontakte eingebracht werden kann.

Der Aufwand für die Herstellung des Basiselements wird dadurch reduziert, dass gemäß einer bevorzugten Ausgestaltung die Leiterpfade als Leiterbahnen ausgebildet sind, die vorzugsweise auf ein aus Kunststoff bestehendes Basiselement aufgedampft sind. Das Aufdampfen der Leiterbahnen auf das aus Kunststoff bestehende Basiselement lässt sich mit geringem Aufwand automatisieren, so dass der Herstellungsaufwand insgesamt reduziert wird. Bezüglich weiterer bevorzugter Ausgestaltungen des Basiselements wird auf die abhängigen Patentansprüche sowie auf die vorstehenden Ausführungen im Zusammenhang mit dem erfindungsgemäßen Filter verwiesen.

Im Einzelnen gibt es nun eine Vielzahl von Möglichkeiten das erfindungsgemäße Filter und das erfindungsgemäße Basiselement auszugestalten und weiterzubilden. Dazu wird verwiesen sowohl auf die den Patentansprüchen 1 und 12 nachgeordneten Patentansprüche, als auch auf die nachfolgende Beschreibung von bevorzugten Ausführungsbeispielen in Verbindung mit der Zeichnung. In der Zeichnung zeigen:
- Fig. 1: ein Ausgestaltungsbeispiel eines erfindungsgemäßen EMV- Filters für ein einphasiges Netz, mit montierten Filterbauelemen- ten,
- Fig. 2: das Basiselement des EMV-Filters gemäß Fig. 1,
- Fig. 3: ein zweites Ausgestaltungsbeispiel eines erfindungsgemäßen EMV-Filters für ein einphasiges Netz, mit montierten Filterbau- elementen,
- Fig. 4: das Basiselement des EMV-Filters gemäß Fig. 3,
- Fig. 5: ein Ausgestaltungsbeispiel eines erfindungsgemäßen EMV- Filters für ein dreiphasiges Netz, mit montierten Filterbauele- menten, und
- Fig. 6: das Basiselement des EMV-Filter gemäß Fig. 5.

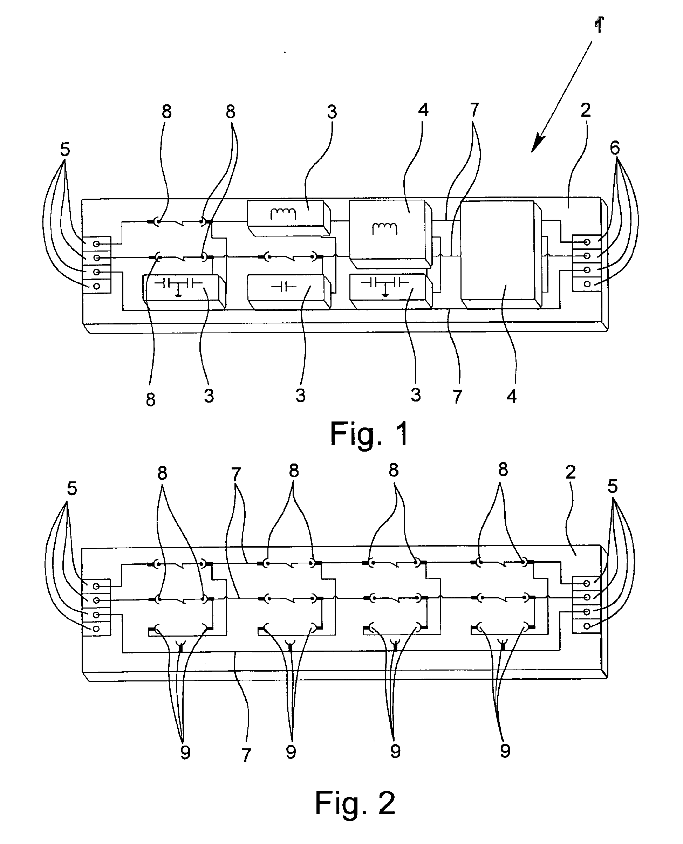

Fig. 1 zeigt ein Ausführungsbeispiel eines erfindungsgemäßen Filters 1 mit einem Basiselement 2, wobei das Basiselement 2 teilweise mit Filterbauelementen 3 und Kombinations-Filterbauelementen 4 bestückt ist, und wobei das Basiselement 2 auf der linken Seite vier Eingangs-Anschlusskontakte 5 und auf der rechten Seite vier Ausgangs-Anschlusskontakte 6 aufweist. Die Eingangs-Anschlusskontakte 5 sind über drei auf dem Basiselement 2 angeordnete Leiterpfade 7 mit den Ausgangs-Anschlusskontakten 6 verbunden. Der vierte Eingangs-Anschlusskontakt 5 und der vierte Ausgangs-Anschlusskontakt 6, die nicht miteinander über einen Leiterpfad verbunden sind, bieten die Möglichkeit das Basiselement 2 mit Masse zu verbinden.

In den beiden in den Fig. 1 und 2 oben angeordneten Leiterpfaden 7 sind jeweils acht Längskontakte 8 vorgesehen, die bei dem Ausführungsbeispiel gemäß Fig. 1 teilweise mit Filterbauelementen 3 und mit Kombinations-Filterbauelementen 4 elektrisch verbunden sind. Des Weiteren sind in allen drei Leiterpfaden 7 vier Querkontakte 9 vorgesehen, wobei über die Querkontakte 9 bei aufgestecktem Filterbauelement 3 oder Kombinations-Filterbauelement 4 eine Querverbindung zwischen zwei Leiterpfaden 7 herstellbar ist. Im Ausführungsbeispiel gemäß Fig. 1 ist auf den Querkontakten 9, die in der Zeichnung ganz rechts dargestellt sind, ein Kombinations-Filterbauelement 4 aufgesteckt, während auf die anderen, weiter links angeordneten Querkontakte 9 jeweils ein Filterbauelement 3 aufgesteckt ist. Bei dem Ausführungsbeispiel gemäß Fig. 1 sind insgesamt vier einzelne Filterbauelemente 3 und zwei Kombinations-Filterbauelemente 4 auf das Basiselement 2 aufgesteckt.

Eine beispielhafte Anordnung der Längskontakte 8 und der Querkontakte 9 in den Leiterpfaden 7 lässt sich der Fig. 2 entnehmen, in der ein Basiselement 2 eines erfindungsgemäßen Filters 1 ohne Filterbauelemente 3 und ohne Kombinations-Filterbauelemente 4 gezeigt ist. Bei der Ausgestaltung des Basiselements 2 gemäß der Fig. 2 lassen sich die Leiterpfade 7 jeweils an vier Stellen über die Querkontakte 9 miteinander verbinden. Der in Fig. 2 als unterster dargestellte Leiterpfad 7 weist lediglich vier Querkontakte 9 auf, während die beiden anderen Leiterpfade 7 jeweils sowohl vier Querkontakte 9 als auch acht Längskontakte 8 aufweisen.

Zwischen zwei einander zugeordneten Längskontakten 8 eines Leiterpfads 7 ist jeweils ein Öffner geschaltet, so dass die Längskontakte 8 elektrisch direkt miteinander verbunden sind, wenn kein Filterbauelement 3 oder kein Kombinations-Filterbauelement 4 auf die Längskontakte 8 aufgesteckt ist. Ist dagegen ein Filterbauelement 3 oder Kombinations-Filterbauelement 4 auf die Längskontakte 8 aufgesteckt, so führt die elektrische Verbindung zwischen den beiden Längskontakten 8 nur noch über das Filterbauelement 3 bzw. das Kombinations-Filterbauelement 4. Wird ein elektrisches Filterbauelement 3 oder ein Kombinations-Filterbauelement 4 auf die Querkontakte 9 mindestens zweier Leiterpfade 7 aufgesteckt, so werden dadurch die entsprechenden Leiterpfade 7 über das Filterbauelement 3 bzw. das Kombinations-Filterbauelement 4 miteinander verbunden. Die Querkontakte 9 der Leiterpfade 7 dienen somit der elektrischen Verbindung zwischen mindestens zwei Leiterpfaden 7.

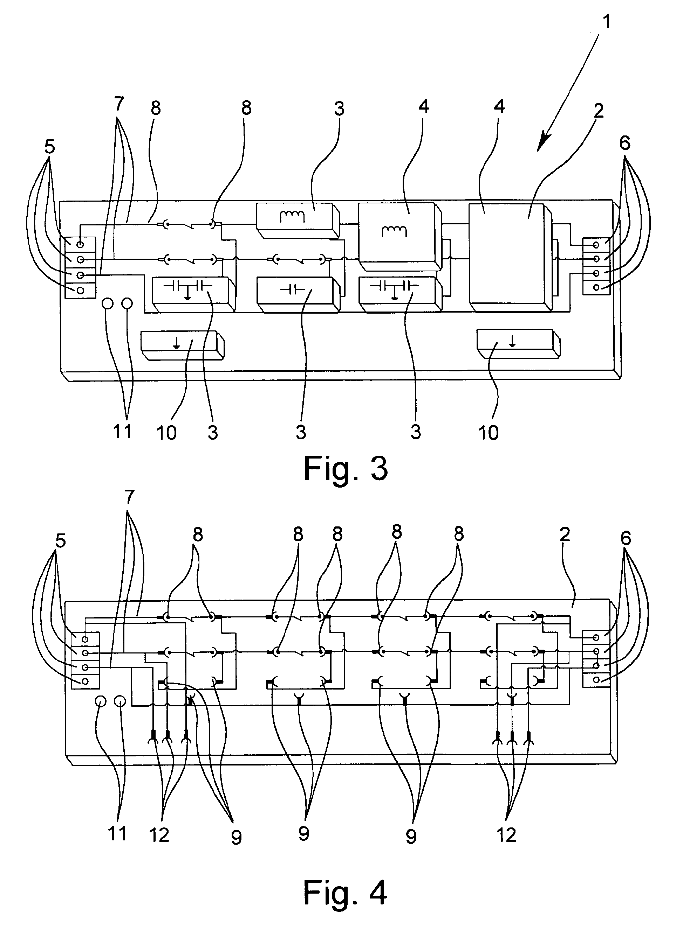

Fig. 3 zeigt ein Ausführungsbeispiel des erfindungsgemäßen Filters 1 gemäß der Fig. 1, bei dem zusätzlich zwei Überspannungsschutzelemente 10 auf dem Basiselement 2 aufgesteckt sind, die die Leiterpfade 7 vor Überspannungen schützen. Außerdem weist das Basiselement 2 zusätzlich zwei LEDs als Anzeigeelemente 11 auf. Die Anzeigeelemente 11 signalisieren in Abhängigkeit von einem Schwell- bzw. Ausgangswert, ob die mit den angebrachten Filterbauelementen 3 bzw. Kombinations-Filterbauelementen 4 erreichte Filterwirkung ausreichend ist oder nicht. Die Überspannungsschutzelemente 10 sind in die in der Fig. 4 dargestellten Überspannungsschutzkontakte 12 eingesteckt, wobei die Überspannungsschutzkontakte 12 jeweils mit einem Leiterpfad 7 verbunden sind. Die Anordnung der Längskontakte 8 und der Querkontakte 9 entspricht der im Zusammenhang mit der Fig. 2 beschriebenen Anordnung, wobei bei dem Ausführungsbeispiel gemäß Fig. 3 und 4 ergänzend die Überspannungsschutzkontakte 12 vorgesehen sind.

Die Filterbauelemente 3 und die Kombinations-Filterbauelemente 4 sind bei den dargestellten Ausführungsbeispielen auf das Basiselement 2 aufsteckbar, wozu die Filterbauelemente 3 und die Kombinations-Filterbauelemente 4 Steckerstifte aufweisen, die zu den als Steckerbuchsen ausgebildeten Längskontakten 8 und Querkontakten 9 korrespondieren. Das Filter 1 gemäß Fig. 3 und das Basiselement 2 gemäß Fig. 4 eignen sich ebenso wie das Filter 1 gemäß Fig. 1 und das Basiselement 2 gemäß Fig. 2 in den dargestellten Ausgestaltungen insbesondere für einphasige Systeme.

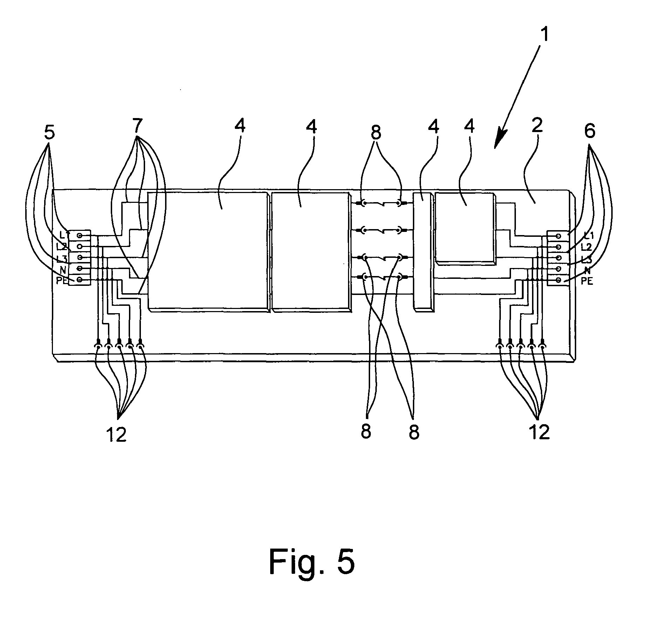

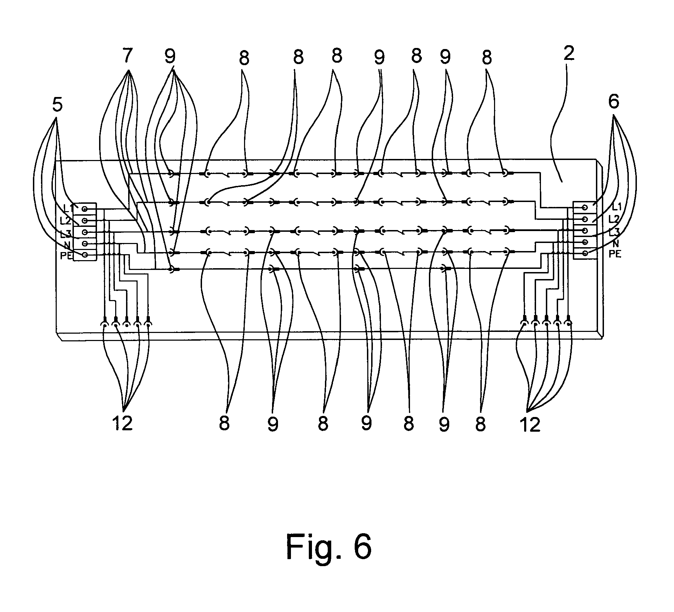

Fig. 5 zeigt eine Ausführungsform eines erfindungsgemäßen Filters 1 für ein dreiphasiges Netz, wobei bei dieser Ausgestaltung vier Kombinations-Filterbauelemente 4 auf das Basiselement 2 aufgesteckt sind, die jeweils sowohl auf Querkontakten 9 als auch auf Längskontakten 8 der Leiterpfade 7 aufgesteckt sind. Entsprechend Fig. 3 können auch bei dem in Fig. 5 dargestellten Filter 1 zum Schutz der Leiterpfade 7 als Stecker ausgebildete Überspannungsschutzelement 10 auf die Überspannungsschutzkontakte 12 aufgesteckt werden. In Fig. 6 ist das Basiselement 2 gemäß Fig. 5 ohne Kombinations-Filterbauelemente 4 dargestellt. Das in den Fig. 5 und 6 dargestellte Basiselement 2 weist bei dieser Ausgestaltung fünf Eingangs-Anschlusskontakte 5 und fünf Ausgangs-Anschlusskontakte 6 auf, die über fünf Leiterpfade 7 jeweils miteinander elektrisch verbunden sind. Der in der Zeichnung dargestellte unterste Leiterpfad 7 weist bei dieser Ausgestaltung nur Querkontakte 9 auf, während die vier anderen Leiterpfade 7 jeweils sowohl vier Querkontakte 9 als auch acht Längskontakte 8 aufweisen. Jeder der fünf Leiterpfade 7 ist mit zwei Überspannungsschutzkontakten 12 verbunden.

## Patentansprüche

1. Filter, insbesondere zur Filterung von elektromagnetischen Störungen, mit einem Basiselement (2), mit mindestens einem elektrischen Filterbauelement (3, 4) und mit mindestens zwei Eingangs-Anschlusskontakten (5) und mindestens zwei Ausgangs-Anschlusskontakten (6) zum Anschluss der Leiter einer elektrischen Leitung, wobei die Eingangs-Anschlusskontakte (5) über auf dem Basiselement (2) angeordnete Leiterpfade (7) mit den Ausgangs-Anschlusskontakten (6) verbunden sind,
**dadurch gekennzeichnet,**
**dass** in jedem Leiterpfad (7) mindestens zwei Längskontakte (8) vorgesehen sind, über die ein Filterbauelement (3, 4) derart mit einem Leiterpfad (7) elektrisch verbindbar ist, dass die elektrische Verbindung des Leiterpfades (7) zwischen den beiden Längskontakten (8) über das Filterbauelement (3, 4) führt, und
**dass** in den Leiterpfaden (7) jeweils mindestens ein Querkontakt (9) vorgesehen ist, so dass zwei Leiterpfade (7) über ein Filterbauelement (3, 4) elektrisch miteinander verbunden sind, wenn das Filterbauelement (3, 4) mit den Querkontakten (9) der beiden Leiterpfade (7) elektrisch verbunden ist.

2. Filter nach Anspruch 1, **dadurch gekennzeichnet, dass** ein weiterer Leiterpfad (7) auf dem Basiselement (2) angeordnet ist, und dass in dem weiteren Leiterpfad (7) mindestens ein Querkontakt (9) vorgesehen ist, so dass der weitere Leiterpfad (7) über ein Filterbauelement (3, 4) mit einem anderen Leiterpfad (7) elektrisch verbunden ist, wenn das Filterbauelement (3, 4) mit den Querkontakten (9) der beiden Leiterpfade (7) elektrisch verbunden ist.

3. Filter nach Anspruch 1 oder 2, **dadurch gekennzeichnet, dass** insgesamt drei Leiterpfade (7) auf dem Basiselement (2) angeordnet sind, wobei zwei Leiterpfade (7) sowohl Längskontakte (8) als auch Querkontakte (9) und ein Leiterpfade (7) nur Querkontakte (9) aufweist, wobei vorzugsweise der nur Querkontakte (9) aufweisende Leiterpfad (7) mit den beiden anderen Leiterpfaden (7) über mindestens ein Filterbauelement (3, 4) elektrisch verbindbar ist.

4. Filter nach Anspruch 1 oder 2, **dadurch gekennzeichnet, dass** insgesamt fünf Leiterpfade (7) auf dem Basiselement (2) angeordnet sind, wobei vier Leiterpfade (7) sowohl Längskontakte (8) als auch Querkontakte (9) und ein Leiterpfade (7) nur Querkontakte (9) aufweist, wobei vorzugsweise der nur Querkontakte (9) aufweisende Leiterpfad (7) mit den vier anderen Leiterpfaden (7) über mindestens ein Filterbauelement (3, 4) elektrisch verbindbar ist.

5. Filter nach Anspruch 3 oder 4, **dadurch gekennzeichnet, dass** die Leiterpfade (7), die sowohl Längskontakte (8) als auch Querkontakte (9) aufweisen sowohl mit dem Leiterpfad (7), der nur Querkontakte (9) aufweist als auch untereinander über jeweils mindestens ein Filterbauelement (3, 4) elektrisch verbindbar sind.

6. Filter nach einem der Ansprüche 1 bis 5, **dadurch gekennzeichnet, dass** ein Filterbauelement (3, 4) eine Kapazität, insbesondere einen Kondensator und/oder eine Induktivität, insbesondere eine Drossel und/oder einen Widerstand aufweist, wobei vorzugsweise die Kapazität und/oder die Induktivität und/oder der Widerstand des Filterbauelements (3, 4) einstellbar ist.

7. Filter nach einem der Ansprüche 1 bis 6, **dadurch gekennzeichnet, dass** die Längskontakte (8) und die Querkontakte (9) als Steckkontakte, insbesondere als Steckerbuchsen ausgebildet sind und die Filterbauelemente (3, 4) korrespondierende Gegensteckkontakte, insbesondere Steckerstifte aufweisen.

8. Filter nach einem der Ansprüche 1 bis 7, **dadurch gekennzeichnet, dass** die Eingangs-Anschlusskontakte (5) und die Ausgangs-Anschlusskontakte (6) als Steckkontakte, insbesondere als Steckerbuchsen ausgebildet sind.

9. Filter nach einem der Ansprüche 1 bis 8, **dadurch gekennzeichnet, dass** das Basiselement (2) mit mindestens einem Überspannungsschutzelement (10) verbindbar ist, das die einzelnen Leiterpfade (7) gegen Überspannungen schützt.

10. Filter nach einem der Ansprüche 1 bis 8, **dadurch gekennzeichnet, dass** das Basiselement (2) mindestens eine, vorzugsweise zwei Anzeigeelemente (11), insbesondere zwei unterschiedlich farbige LEDs aufweist, die die Filterwirkung in Abhängigkeit von der Art, der Anzahl und der Position der auf die Längskontakte (8) und/oder auf die Querkontakte (9) aufgesteckten Filterbauelemente (3, 4) anzeigt.

11. Filter nach einem der Ansprüche 1 bis 10, **dadurch gekennzeichnet, dass** auf dem Basiselement (2) ein Deckel montierbar, insbesondere aufsteckbar ist, wobei der Deckel vorzugsweise aus einem mit einer Metallschicht bedampften Kunststoff oder aus Metall besteht.

12. Basiselement für ein Filter (1), insbesondere nach einem der Ansprüche 1 bis 11, mit mindestens zwei Eingangs-Anschlusskontakten (5) und mindestens zwei Ausgangs-Anschlusskontakten (6) zum Anschluss der Leiter einer elektrischen Leitung, wobei die Eingangs-Anschlusskontakten (5) über Leiterpfade (7) mit den Ausgangs-Anschlusskontakten (6) verbunden sind,
**dadurch gekennzeichnet,**
**dass** in jedem Leiterpfad (7) mindestens zwei Längskontakte (8) zur elektrischen Verbindung mit einem Filterbauelement (3, 4) ausgebildet sind, so dass die elektrische Verbindung des Leiterpfades (7) zwischen den beiden Längskontakten (8) über das Filterbauelement (3, 4) führt, wenn ein Filterbauelement (3, 4) mit den Längskontakten (8) des Leiterpfades (7) elektrisch verbunden wird, und
**dass** in den Leiterpfaden (7) jeweils mindestens ein Querkontakt (9) ausgebildet ist, so dass zwei Leiterpfade (7) über ein Filterbauelement (3, 4) elektrisch miteinander verbindbar sind, wenn ein Filterbauelement (3, 4) mit den Querkontakten (9) zweier Leiterpfade (7) elektrisch verbunden wird.

13. Basiselement nach Anspruch 12, **dadurch gekennzeichnet, dass** mindestens drei Leiterpfade (7) auf dem Basiselement (2) angeordnet sind, wobei ein Leiterpfad (7) nur Querkontakte (9) aufweist und die anderen Leiterpfade (7) sowohl Längskontakte (8) als auch Querkontakte (9) aufweisen.

14. Basiselement nach Anspruch 12 oder 13, **dadurch gekennzeichnet, dass** die Längskontakte (8), die Querkontakte (9) und vorzugsweise auch die Eingangs-Anschlusskontakte (5) und die Ausgangs-Anschlusskontakte (6) als Steckkontakte, insbesondere als Steckerbuchsen ausgebildet sind.

15. Basiselement nach einem der Ansprüche 12 bis 14, **dadurch gekennzeichnet, dass** mindestens ein Überspannungsschutzelement (10) vorgesehen ist, das die einzelnen Leiterpfade (7) gegen Überspannungen schützt, wobei das Überspannungsschutzelement (10) bzw. die Überspannungsschutzelemente (10) vorzugsweise über einen Montagefuß mit einer Tragschiene verbindbar sind, auf die das Basiselement (2) aufrastbar ist.
